# EUROPEAN PATENT APPLICATION

(11) **EP 3 648 002 A1**
(43) Date of publication of application: **06.05.2020**
(21) Application number: 19206011.9
(22) Date of filing: 29.10.2019
(51) Int. Cl.: G06K 9/00, G06K 9/62, G06K 9/20

(54) **CIRCUIT MANAGEMENT SYSTEMS**

(30) Priority: 31.10.2018 US 201816177123
(71) Applicant: Telect, Inc., Liberty Lake, WA 99019 (US)
(72) Inventor: TAKISAKI, Walter Dean, Spokane Valley, Washington 99206 (US)
(74) Representative: Somervell, Thomas Richard

(57) **Abstract**

Systems and methods of managing circuits include capturing, via an image capturing device, an image of a piece of data communication equipment having ports. The systems and methods decompose the image into images of open ports and/or closed ports of the piece of data communication equipment. The images of the open ports are void of a cable plugged thereto and the images of the closed ports have a cable plugged thereto. The systems and methods identify the open ports as being open and identify the closed ports as being closed. The systems and methods provide an indication of the open ports and/or an indication of the closed ports.

## Description

### BACKGROUND

An important consideration in data communication equipment is circuit density. Most central data communication locations have limited space. Therefore, there is a need to reduce the size of data communication equipment, and install as much data communication equipment as possible in a relatively small space at a central data communication location.

For service providers (e.g., Google LLC, Microsoft Corporation, Yahoo!, Amazon.com, Inc., etc.) fully utilizing the installed data communication equipment at a central data communication location can be a challenging process in which service providers use data center information management systems (DCIMS) to track circuits, equipment, architecture, and customers to fully utilize the floor space and meet the high density needs of the central data communication locations. This is particularly true for optical fiber communication lines, where service providers manage thousands of open ports and thousands of closed ports for thousands of terminations of optical fiber communication lines. For example, service providers may manage thousands of patch ports for thousands of cables. Thus, to fully utilize the installed data communication equipment a service provider must track which patch ports are open patch ports and which patch ports are closed patch ports.

To track which ports are open ports and which ports are closed ports, a service provider may utilize patch cords having an identifier (e.g., a radio-frequency identifier (RFID), a printed circuit board (PCB), etc.) arranged in a connector of each patch cord. For example, a service provider may utilize RFID patch cords and RFID sensor panels that communicate connectivity information when an RFID patch cord is plugged into a port of the RFID sensor panels. In another example, a service provider may utilize PCB patch cords and PCB sensor panels that communicate connectivity information when a PCB patch cord is plugged into a port of the PCB sensor panels.

However, these RFID and PCB tracking systems are expensive to install and are not easily used with existing data communication equipment already installed in central data communication locations.

Accordingly, there remains a need in the art for circuit tracking systems that are inexpensive to install and are easily used with existing data communication equipment already installed in central data communication locations.

### SUMMARY

Systems and methods are described which are configured to manage circuits. Generally, the systems and methods capture an image of a piece of data communication equipment having ports, and identify ports as being open ports and/or identify ports as being closed ports. This summary is provided to introduce simplified concepts of systems and methods that manage circuits, which are further described below in the Detailed Description. This summary is not intended to identify essential features of the claimed subject matter, nor is it intended for use in determining the scope of the claimed subject matter.

In an embodiment, a method of managing circuits may include an image capturing device capturing an image of a piece of data communication equipment having ports. The image may be decomposed into images of open ports of the piece of data communication equipment. In some examples, the images of the open ports may be void of a cable plugged thereto. The method may include identifying the open ports as being open and providing an indication of the open ports.

In another embodiment, a method of managing circuits may include receiving data representing an image, captured via an image capturing device, of a piece of data communication equipment having ports. The data may be decomposed into data sets representing images of the ports. The data sets representing the images of the ports may be compared to a trained data set of known images of open ports. In some examples, the images of the open ports may be void of a cable plugged thereto. The method may include identifying, based at least in part on the comparing, a port of the images of the ports as being an open port.

In another embodiment, a method of managing circuits may include receiving data representing an image, captured via an image capturing device, of a piece of data communication equipment having ports. The data may be decomposed into data sets representing images of the ports. The data sets representing the images of the ports may be compared to a trained data set of known images of closed ports. In some examples, the images of the closed ports may have a cable plugged thereto. The method may include identifying, based at least in part on the comparing, a port of the images of the ports as being a closed port.

### BRIEF DESCRIPTION OF THE DRAWINGS

The detailed description is set forth with reference to the accompanying figures. In the figures, the left-most digit(s) of a reference number identifies the figure in which the reference number first appears. The use of the same reference numbers in different figures indicates similar or identical items.
FIG. 1 illustrates an example central data communication location including data communication equipment installed therein.
FIG. 2 illustrates a front view of an example frame installable in the central data communication location shown in FIG. 1.
FIG. 3 illustrates a perspective view of an example panel receivable by the frame shown in FIG. 2 with a patch tray in an open position.
FIG. 4 illustrates a perspective view of an example patch tray, receivable by the panel shown in FIG. 3, having ports.
FIG. 5 illustrates an example implementation of a network infrastructure including an information management server.
FIG. 6 illustrates an example method for managing circuits.
FIG. 7 illustrates another example method for managing circuits.

### DETAILED DESCRIPTION

### Overview

This disclosure is directed to systems and methods that manage circuits. For example, the systems and methods may provide for managing fiber optic circuits. Image capturing devices may capture images of data communication equipment having ports. For example, a device (e.g., a smartphone, a tablet, personal digital assistant (PDA), hand scanner, etc.), a digital camera, a digital video recorder (DVR), an action camera, surveillance camera, a wearable computer (e.g., smart glasses, smart wristwatch, etc.), augmented reality glasses, virtual reality glasses, etc. may capture images of ports of a piece of data communication. The ports may be identified as being open ports or identified as being closed ports. For example, the open ports may be identified as being void of a cable plugged thereto, and the closed ports may be identified as having a cable plugged thereto. The ports may include fiber optic ports. The images of the open ports may be images of open fiber optic ports that are void of a fiber optic cable plugged thereto, and the images of the closed ports may be images of closed fiber optic ports having a fiber optic cable plugged thereto. Because the ports may be identified as being open ports or identified as being closed ports, a service provider (e.g., Google LLC, Microsoft Corporation, Yahoo!, Amazon.com, Inc., etc.) may manage open ports and closed ports of thousands of circuits to fully utilize floor space of central data communication locations and meet the high density needs of the central data communication locations. For example, because a service provider may be provided with an indication of what patch ports are open patch ports, the service provider may choose to patch additional cables with the available open patch ports to fully utilize the data communication equipment already installed at the central data communication location.

Moreover, because image capturing devices may capture images of data communication equipment having ports, where the ports may be identified as being open ports or identified as being closed ports, a service provider may elect to not utilize costly tracking systems having identifiers (e.g., a radio-frequency identifier (RFID), a printed circuit board (PCB), etc.) arranged in a connector of each patch cord that cooperate with sensor panels (e.g., RFID sensor panels, PCB sensor panels, etc.). Rather, a service provider may elect to utilize image capturing devices that may be used with existing data communication equipment already installed in central data communication locations.

In another example, an image capturing device may capture an image of a piece of data communication equipment having ports. Data representing the image, captured via the image capturing device may be decomposed into data sets representing images of the ports. In an embodiment, the data sets representing the images of the ports may be compared to a trained data set of known images of open ports. Further, the images of the open ports may be void of a cable plugged thereto, and the images of the closed ports may have a cable plugged thereto. Based at least in part on the comparing of the ports to the trained data sets, a port may be identified as being an open port or identified as being a closed port.

In another example, an artificial intelligence (AI) algorithm may be used to identify data communication equipment to include frames, chassis, trays and/or ports. An AI algorithm application may be stored on an image capturing device, in a central server or in both locations. The AI algorithm may use machine learning and/or pattern recognition to identify the ports. For example, the AI algorithm may use machine learning and/or pattern recognition to identify at least one of the ports as being an open port or a closed port. The AI algorithm may be, for example, a Microsoft Computer Vision API, Amazon Rekognition, a Google Cloud Vision API, OpenCV, SimpleCV, etc.

A provider of the systems and methods that manage circuits may utilize a trained data set of known images of open ports and/or a trained data set of known images of closed ports to train the AI algorithm to identify an open port and a closed port. For example, a provider may utilize a trained data set of known images of open ports and/or a trained data set of known images of closed ports to train the AI algorithm to identify an open port within a predetermined probability and to identify a closed port within a predetermined probability. For example, a provider may utilize a trained data set of known images of open ports void of a cable plugged thereto to train the AI algorithm to identify a port void of a cable plugged thereto as being an open port and a port having a cable plugged thereto as being a closed port, each within a predetermined probability, as indicated above. Training of the AI algorithm to identify a port as being an open port or a closed port may be supervised training, semi-supervised training, unsupervised training, or a combination thereof.

In another example, an AI algorithm may be used to determine location information of the identified ports relative to a piece of data communication equipment. For example, an AI algorithm may be used to determine location information, of an identified open port or an identified closed port, relative to the piece of data communication equipment. An information management server (e.g., a central server) may store the location information of the open port and closed port in memory. The information management server may associate the location information, of the open port, with a representative location in a digital representation of the piece of data communication equipment, to create a map of a digital representation of open ports arranged in the piece of data communication equipment. Similarly, the information management server may associate the location information, of the closed port, with a representative location in a digital representation of the piece of data communication equipment, to create a map of a digital representation of closed ports arranged in the piece of data communication equipment. The map of the digital representation of the open and/or closed ports may be used to provide connectivity information for the massive amounts of terminations of optical fiber communication lines in the data communication equipment installed at central data communication locations. In one example, a user (e.g., a provider, a service provider, an engineer, a technician, an employee, etc.) may utilize the map of the digital representation of the open and/or closed ports to add new additional terminations of optical fiber communication lines in the data communication equipment installed at central data communication locations. In another example, the user may utilize the map of the digital representation of the open and/or closed ports to change locations of existing terminations of optical fiber communication lines in the data communication equipment installed at central data communication locations. In another example, a user may utilize the map of the digital representation of the open and/or closed ports to study quantities and/or locations of the open and/or closed ports to fully utilize the installed data communication equipment.

### Illustrative Data Communication Apparatuses

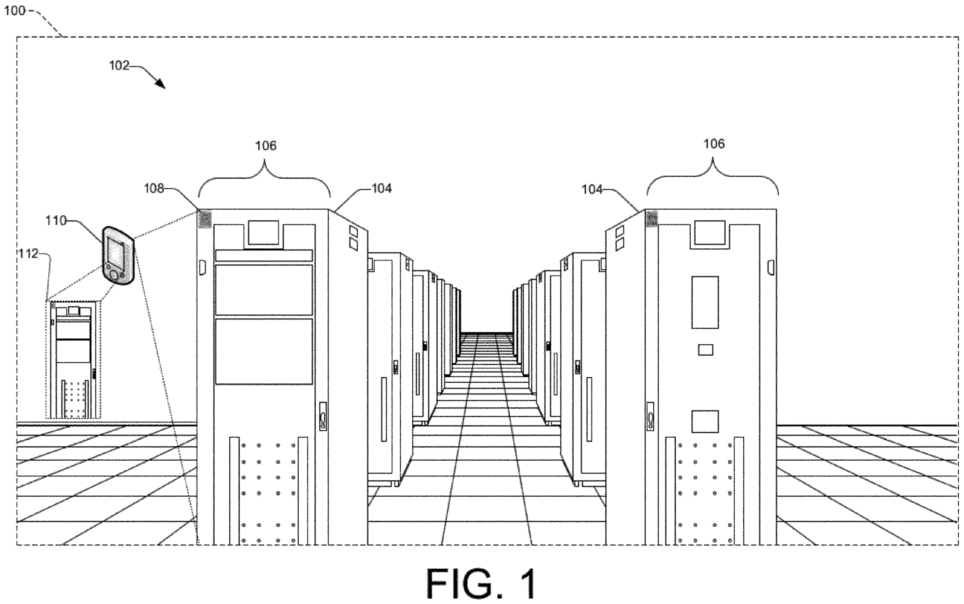

FIG. 1 illustrates an example central data communication location 100 including data communication equipment 102 installed therein. The data communication equipment 102 may include a plurality of frames 104 arranged in rows 106. The frames 104 may be front access side frames or front access and back access side frames. The frames 104 may include one or more chassis, one or more panels, and one or more trays. In one example, each frame 104 may have capacity to receive about 3,000 fiber terminations. In another example, each frame 104 may have capacity to receive about 7,000 fiber terminations.

Fiber terminations may be splice termination and/or patch terminations. A splice termination may be two separate fibers (e.g., separate pieces of glass) being joined together through a splice (e.g., joining two fibers end-to-end). A patch termination may be separate fibers (e.g., separate cables) terminated in a connector (e.g., Lucent Connectors (LCs), subscriber connectors (SC), etc.)) having an end condition (e.g., an angle-polished connector (APC) end condition or an ultra-polished connector (UPC) end condition). In the patch termination, the separate fibers terminated in the connector may then be inserted into a port (e.g., an adapter, a pop-up adapter, a pop-up adapter pack, a coupler, etc), where the port may provide for an additional cable to be inserted into the opposite end providing a continuous path for light to pass through. The frames 104, chassis, panels, or trays may include one or more ports.

An identifier 108 may be arranged with the frames 104 that identifies the frames 104. For example, the identifier 108 may be arranged on a front of the frames 104 that identifies locations of the frames 104. While FIG. 1 illustrates the identifier 108 may be arranged on a front of the frames 104, the identifier 108 may be arranged on a wall, a post, a column, a floor, a map etc. proximate or adjacent to a frame 104. Further, while FIG. 1 illustrates the identifier 108 may be a machine-readable code (e.g., a Quick Response Code (QR code), a bar code, universal product code (UPC), etc.) that identifies a frame 104, the identifier 108 may be one or more alphabetical/symbolic characters and/or one or more numerical characters that identify a frame 104. For example, the one or more alphabetical/symbolic characters and/or the one or more numerical characters that identify a frame 104 may be an address of a frame 104. The address of a frame 104 may include a row number and a frame number. For example, the address of a frame 104 may be the first frame in the first row.

An image capturing device 110 may capture an image 112 of the data communication equipment 102. For example, as a user (e.g., an engineer, a technician, etc.) approaches the frame 104, the image capturing device 110 may capture the image 112 of the front of the frame 104. In one example, the user may selectively capture the image 112 of the front of the frame 104 via the image capturing device 110. For example, the user may activate the image capturing device 110 to capture the image 112 of the front of the frame 104. In another example, the image capturing device 110 may store, in memory, an artificial intelligence (AI) algorithm application that may automatically capture the image 112 of the front of the frame 104 via the image capturing device 110. For example, the AI algorithm may be trained to identify a front of a frame and to activate the image capturing device 110 to capture the image 112 of the front of the frame 104 when the AI algorithm identifies the front of the frame 104. In another example, the user may selectively scan the identifier 108 via the image capturing device 110. While FIG. 1 illustrates the image capturing device 110 may be a portable, the image capturing device may not be portable. For example, the image capturing device 110 may be fixed in the area on a wall, a post, a column, a ceiling, a floor, a bar, etc. proximate or adjacent to a frame 104. Further, the image capturing device 110 may be arranged on a frame. For example, the image capturing device may be arranged on a door, a top surface, a side surface, a bottom surface, an inside surface, of a frame. While FIG. 1 illustrates one image capturing device 110, any number of image capturing devices 110 may be used. The AI algorithm may receive data representing the image 112, captured via the image capturing device 110, of the data communication equipment 102. The AI algorithm may decompose the data into data sets representing images of identifiers associated with the piece of data communication equipment 102. The AI algorithm may compare the data sets representing the images of the identifiers to a trained data set of known images of identifiers. For example, the AI algorithm may compare the data sets representing images of the identifiers to a trained data set of known images of frames, chassis, trays, machine-readable codes, known images of one or more alphabetical characters, or known images of one or more numerical characters. The AI algorithm may identify, based at least in part on the comparing, at least one image of an identifier of the images of identifiers as being the identifier 108. The AI algorithm may associate the at least one image of the identifier 108 with the frame 104. In one example, the AI algorithm may determine the image of the identifier 108 is within a threshold distance of the front of the frame 104 and associate the at least one image of the identifier 108 with the frame 104. In another example, the AI algorithm may receive data representing association information indicating the at least one image of the identifier 108 is associated with the frame 104. For example, the AI algorithm may receive the data representing association information indicating the at least one image of the identifier 108 is associated with the frame 104 from the information management server.

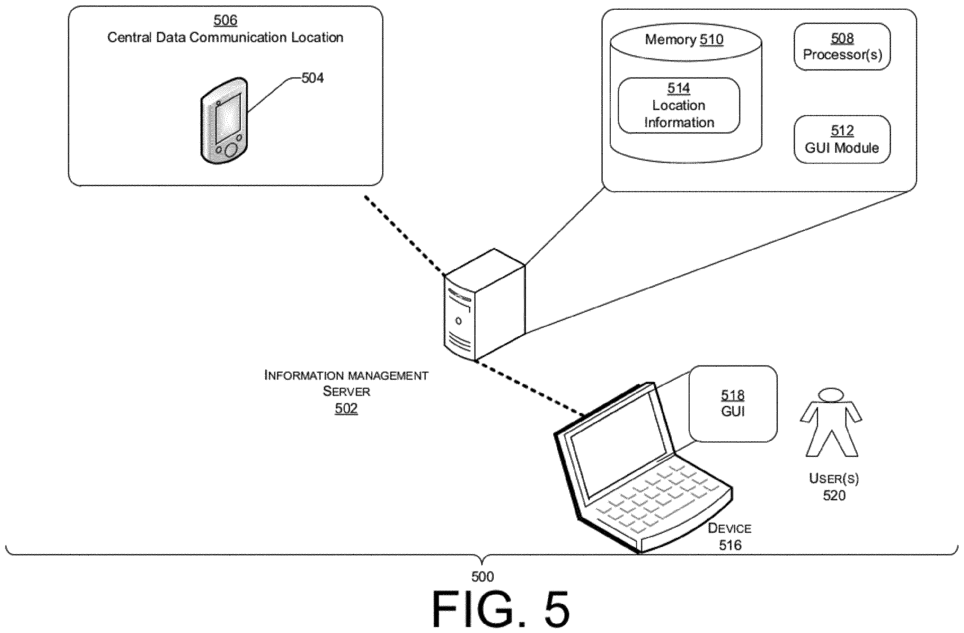

Based at least in part on the AI algorithm associating the at least one image of the identifier 108 with the frame 104, an information management server (discussed in more detail below with regard to FIG. 5) may store location information of the image capturing device 110. The information management server may associate the location information of the image capturing device 110 with a representative location in a digital representation of the central data communication location 100 to store the location of the image capturing device 110. The location information of the image capturing device 110 may further include Global Position System (GPS) information, Wi-Fi-based position system (WPS) information, mobile phone position information, etc.

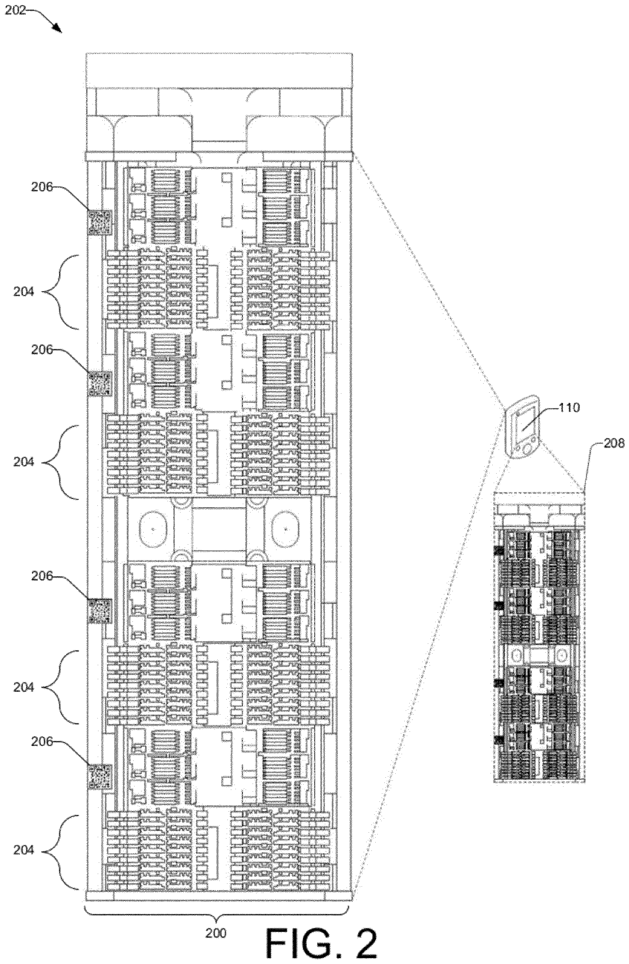

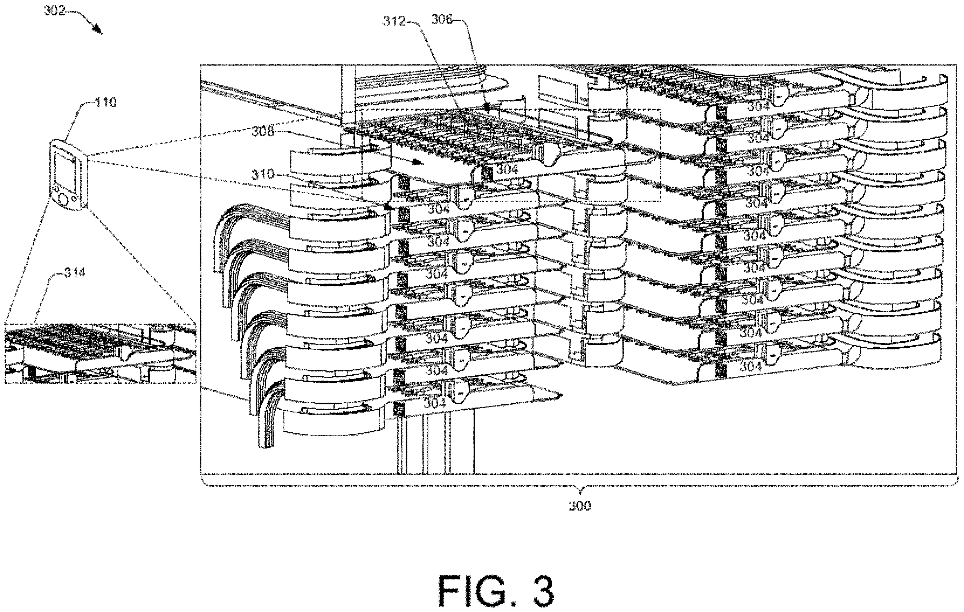

FIG. 2 illustrates a front view 200 of an example frame 202 installable in the central data communication location 100 shown in FIG. 1. The frame 202 may be the same as frame 104. For example, the frame 202 may be the same as the frame 104 the image capturing device 110 captured the image 112 of in the central data communication location 100. Panels 204 (e.g., rack units) may be arranged in the frame 202. Panels 204 may be patch panels (discussed in more detail below with regard to FIG. 3).

An identifier 206 may be arranged with the panels 204 that identifies the panels 204. For example, the identifier 206 may be disposed on a front of the panels 204 that identifies locations of the panels 204. The identifier 206 may be the same as the identifier 108 that identifies an address of the panels 204. For example, the address of a panel 204 may be the first panel, in the first frame, in the first row.

The image capturing device 110 may capture an image 208 of the front of the panels 204. For example, after the user opens the frame 202 to access the panels 204 arranged in the frame 202, the image capturing device 110 may capture the image 208 of the front of the panels 204. In one example, the user may selectively capture the image 208 of the front of the panels 204 via the image capturing device 110. In another example, the AI algorithm may automatically capture the image 208 of the front of the panels 204 via the image capturing device 110. For example, the AI algorithm may be trained to identify an open frame 202 and to activate the image capturing device 110 to capture the image 208 of the front of the panels 204 after the user opens the frame 202. In another example, the user may selectively scan the identifier 206 via the image capturing device 110.

The AI algorithm may receive data representing the image 208, captured via the image capturing device 110, of the front of the panels 204. The AI algorithm may decompose the data into data sets representing images of the identifiers 206 associated with the panels 204. The AI algorithm may compare the data sets representing the images of the identifiers 206 to a trained data set of known images of identifiers. The AI algorithm may identify, based at least in part on the comparing, images of the identifiers as being the identifiers 206. The AI algorithm may associate the images of the identifiers 206 with the panels 204 arranged in the frame 202. In one example, the AI algorithm may determine the images of the identifiers 206 are each within a threshold distance of the panels 204 and associate the images of the identifiers 206 with the panels 204. In another example, the AI algorithm may receive data representing association information indicating the identifiers 206 are associated with the panels 204.

Based at least in part on the AI algorithm associating the images of the identifiers 206 with the panels 204, the information management server may store location information of the image capturing device 110. The central server may associate the location information of the image capturing device 110 with a representative location in the digital representation of the central data communication location 100 to store the location of the image capturing device 110.

FIG. 3 illustrates a perspective view 300 of an example panel 302 receivable by frame 202 shown in FIG. 2. The panel 302 may be the same as the panels 204. For example, the panel 302 may be at least one of the panels 204 the image capturing device 110 captured the image 208 of in the front of the frame 202. The panel 302 may be a patch panel including a plurality of patch trays 304. Each of the plurality of patch trays 304 may be moveable (e.g., slidable) between an open position and a closed position. While FIG. 3 illustrates the panel 302 including a plurality of patch trays 304, the panel 302 may include other types of piece of equipment displaceably arranged in the panel 302. For example, the panel 302 may include an array of ports arranged on displaceable members. For example, the panel 302 may include a first array of ports arranged on a first displaceable member and a second array of ports arranged on a second displaceable member, where the first and second displaceable members pivot or rotate, between an open and/or closed position, relative to the panel 302. While FIG. 3 illustrates the plurality of patch trays 304 are slidable between an open position and a closed position, the plurality of patch trays 304 may be pivotable, rotatable, etc. between an open position and a closed position (e.g., stowed position).

Each patch tray of the plurality of patch trays 304 may include ports 306. The ports 306 may be adapters, pop-up adapters, pop-up adapter packs, couplers, etc. The ports 306 may removeably receive connectors (e.g., Lucent Connectors (LCs), subscriber connectors (SC), etc.)). The connectors may include separate fibers terminated in the connectors.

FIG. 3 illustrates a patch tray 304 in an open position 308 and the other patch trays 304 in closed positions 310. When in the open position 308, a patch tray 304 may be arranged in front of the frame 202 and may provide access to the ports 306 arranged in the patch tray 304. When in the closed position 310, a tray may be arranged in the frame 202 and may not provide access to the ports 306 arranged in the patch tray 304.

An identifier 312 may be associated with each of the patch trays 304 that identifies the patch trays 304. For example, the identifier 312 may be disposed on a front of the patch trays 304 that identifies locations of the patch trays 304. The identifier 312 may be the same as the identifier 108 that identifies an address of the patch trays 304. For example, the address of a patch tray 304 may be patch tray number one, in the first panel, in the first frame, in the first row.

The image capturing device 110 may capture an image 314 of the patch tray 304 in the open position 308. For example, after the user moves the patch tray 304 to the open position 308 to access to the ports 306 arranged in the patch tray 304, the image capturing device 110 may capture the image 314 of the patch tray 304 in the open position 308. In one example, the user may selectively capture the image 314 of the patch tray 304 in the open position 308 via the image capturing device 110. In another example, the AI algorithm may automatically capture the image 314 of the patch tray 304 in the open position 308 via the image capturing device 110. For example, the AI algorithm may be trained to identify a patch tray in an open position and to activate the image capturing device 110 to capture the image 314 of the patch tray 304 in the open position 308 after the user moves the patch tray 304 into the open position 308. In another example, the user may selectively scan the identifier 312 via the image capturing device 110.

The AI algorithm may receive data representing the image 314, captured via the image capturing device 110, of the patch tray 304 in the open position 308. The AI algorithm may decompose the data into data sets representing images of the identifiers 312 associated with the patch trays 304. The AI algorithm may compare the data sets representing the images of the identifiers 312 to a trained data set of known images of identifiers. The AI algorithm may identify, based at least in part on the comparing, at least one image of an identifier of the images of identifiers as being the identifier 312. The AI algorithm may associate the at least one image of the identifier 312 with the patch tray 304 in the open position 308. In one example, the AI algorithm may determine the image of the identifier 312 is within a threshold distance of the patch tray 304 in the open position 308 and associate the at least one image of the identifier 312 with the patch tray 304 in the open position 308. In another example, the AI algorithm may receive data representing association information indicating the at least one image of the identifier 312 is associated with the patch tray 304 in the open position 308.

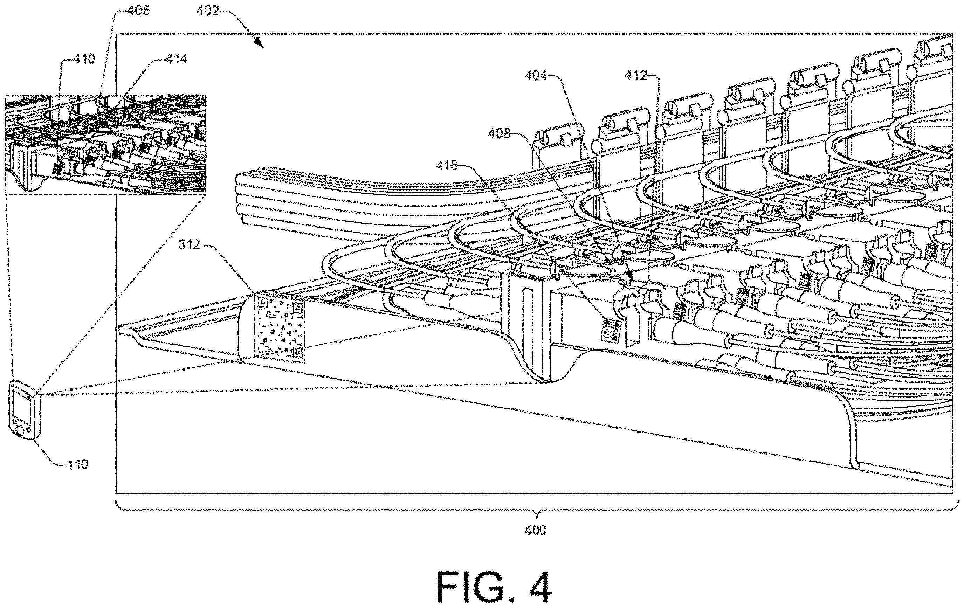

FIG. 4 illustrates a perspective view 400 of an example patch tray 402, receivable by the panel 302 shown in FIG. 3, having ports 404. The patch tray 402 may be the same as the patch trays 304. For example, the patch tray 402 may be the same as the patch tray 304 the image capturing device 110 captured the image 314 of in the open position 308. The ports 404 may be the same as the ports 306 arranged in the tray 304.

The image capturing device 110 may capture an image 406 of the ports 404 in the patch tray 402 in the open position 308. For example, after the user moves the patch tray 402 to the open position 308 to access the ports 404 in the patch tray 402, the image capturing device 110 may capture the image 406 of the ports 404 in the patch tray 402. In one example, the user may selectively capture the image 406 of the ports 404 via the image capturing device 110. In another example, the AI algorithm may automatically capture the image 406 of ports 404 via the image capturing device 110. For example, the AI algorithm may be trained to identify a patch tray in an open position and to activate the image capturing device 110 to capture the image 406 of the ports 404 after the user moves the patch tray 402 into the open position 308.

The AI algorithm may receive data representing the image 406, captured via the image capturing device 110, of the ports 404 arranged in the patch tray 402 in the open position 308. The AI algorithm may decompose the data into data sets representing images of the ports 404.

In one example, the AI algorithm may compare the data sets representing the images of the ports 404 to a trained data set of known images of open ports. For example, the AI algorithm may compare the data sets representing the images of the ports 404 to a trained data set of known images of open ports void of a cable plugged thereto. For example, the AI algorithm may compare the data sets representing the images of the ports 404 to a trained data set of known images of open fiber optic ports (e.g., open fiber optic patch ports) void of a fiber optic cable pugged thereto. For example, the AI algorithm may compare the data sets representing the images of the ports 404 to a trained data set of known images of open adapters, open pop-up adapters, open pop-up adapter packs, open couplers, etc. void of Lucent Connectors (LCs) and/or subscriber connectors (SC) plugged thereto. The AI algorithm may identify, based at least in part on the comparing, a port of the images of the ports 404 as being an open port 408. The AI algorithm may provide an indication 410 of the open port 408. For example, the AI algorithm may provide an icon indicating, outlining, demarcating, signaling, etc., the open port 408 in the image 406 of the ports 404.

In another example, the AI algorithm may compare the data sets representing the images of the ports 404 to a trained data set of known images of closed ports. For example, the AI algorithm may compare the data sets representing the images of the ports 404 to a trained data set of known images of closed ports having a cable plugged thereto. For example, the AI algorithm may compare the data sets representing the images of the ports 404 to a trained data set of known images of closed fiber optic ports (e.g., closed fiber optic patch ports) having a fiber optic cable pugged thereto. For example, the AI algorithm may compare the data sets representing the images of the ports 404 to a trained data set of known images of closed adapters, closed pop-up adapters, closed pop-up adapter packs, closed couplers, etc. having Lucent Connectors (LCs) and/or subscriber connectors (SC) plugged thereto. The AI algorithm may identify, based at least in part on the comparing, a port of the images of the ports 404 as being a closed port 412. The AI algorithm may provide an indication 414 of the closed port 412. For example, the AI algorithm may provide an icon indicating, outlining, demarcating, signaling, etc., the closed port 412 in the image 406 of the ports 404.

In one example, the AI algorithm may determine location information, of the open port 408, relative to the patch tray 402 in the open position 308. For example, the AI algorithm may associate the open port 408 with the patch tray 402 in the open position 308 having been previously associated with the identifier 312. For example, the AI algorithm may associate the open port 408 with the patch tray 402 in the open position 308 if the open port 408 is within a threshold distance of the identifier 312 having been previously associated with the patch tray 402 in the open position 308.

In another example, the AI algorithm may determine location information, of the open port 408, relative to the patch tray 402 in the open position 308 by decomposing the data representing the image 406 into data sets representing images of identifiers 416 associated with the ports 404. The AI algorithm may compare the data sets representing the images of the identifiers 416 to a trained data set of known images of identifiers. The identifiers 416 may be arranged with each of the ports 404 that identifies the ports 404. For example, the identifiers 416 may be arranged on an exterior surface of the ports 404 that identifies an address of the ports 404. The address of a port may be, for example, port number one. The AI algorithm may identify, based at least in part on the comparing, at least one image of an identifier as being the identifier 416. The AI algorithm may associate the at least one image of the identifier with the open port 408. In one example, the AI algorithm may determine the at least one image of the identifier is within a threshold distance of the open port 408 and associate the at least one image of the identifier with the open port 408. In another example, the AI algorithm may receive data representing association information indicating the at least one image of the identifier is associated with the open port 408. In another example, the user may selectively scan the identifier 416 via the image capturing device 110.

The central server may store the location information of the open port 408. In one example, the stored location information of the open port 408 may be a number of open ports (e.g., a quantity of open ports) in patch tray number one, in the first panel, in the first frame, in the first row. In another example, the stored location information of the open port 408 may be a position (e.g., port number 1) of an open port in patch tray number one, in the first panel, in the first frame, in the first row. The central server may associate the location information, of the open port 408, with a representative location in a digital representation of the patch tray 402, to create a map of a digital representation of open ports arranged in the patch tray 402.

In another example, the AI algorithm may determine location information, of the closed port 412, relative to the patch tray 402 in the open position 308. For example, the AI algorithm may associate the closed port 412 with the patch tray 402 in the open position 308 having been previously associated with the identifier 312. For example, the AI algorithm may associate the closed port 412 with the patch tray 402 in the open position 308 if the closed port 412 is within a threshold distance of the identifier 312 having been previously associated with the patch tray 402 in the open position 308.

In another example, the AI algorithm may determine location information, of the closed port 412, relative the patch tray 402 in the open position 308 by decomposing the data representing the image 406 into data sets representing images of identifiers 416 associated with the ports 404. The AI algorithm may compare the data sets representing the images of the identifiers 416 to a trained data set of known images of identifiers. The identifiers 416 may be arranged with each of the ports 404 that identifies the ports 404. For example, the identifiers 416 may be arranged on an exterior surface of the ports 404 that identifies an address of the ports 404. The address of a port may be port number one. The AI algorithm may identify, based at least in part on the comparing, at least one image of an identifier as being the identifier 416. The AI algorithm may associate the at least one image of the identifier with the closed port 412. In one example, the AI algorithm may determine the at least one image of the identifier is within a threshold distance of the closed port 412 and associate the at least one image of the identifier with the closed port 412. In another example, the AI algorithm may receive data representing association information indicating the at least one image of the identifier is associated with the closed port 412.

The central server may store the location information of the closed port 412. In one example, the stored location information of the closed port 412 may be a number of closed ports (e.g., a quantity of closed ports) in patch tray number one, in the first panel, in the first frame, in the first row. In another example, the stored location information of the closed port 412 may be a position (e.g., port number 1) of a closed port in patch tray number one, in the first panel, in the first frame, in the first row. The central server may associate the location information, of the closed port 412, with a representative location in a digital representation of the patch tray 402, to create a map of a digital representation of closed ports arranged in the patch tray 402.

### Illustrative Information Management System

FIG. 5 illustrates an example implementation of a network infrastructure 500 including an information management server 502. In one example, the information management server 502 may be a data center information management systems (DCIMS) server operated by a service provider (e.g., Google LLC, Microsoft Corporation, Yahoo!, Amazon.com, Inc., etc.). In another example, the information management server(s) 502 may be communicatively connected with the DCIMS server operated by a service provider.

The information management server 502 may be communicatively connected with image capturing device(s) 504 located in central data communication location(s) 506. The image capturing device(s) 504 may be the same as the image capturing device 110 discussed above. The central data communication location(s) may be the same as the central data communication location 100 discussed above. While FIG. 5 illustrates the information management server 502 may be communicatively connected with one image capturing device 504 located in one central data communication location 506, the information management server 502 may be communicatively connected with a plurality of image capturing devices located in a plurality of central data communication locations.

FIG. 5 illustrates the information management server 502 may comprise a processor(s) 508, memory 510, and a GUI module 512. The memory 510 may be configured to store instructions executable on the processor(s) 508, and may comprise location information 514 of open ports (e.g., open port 408) and/or closed ports (e.g., closed port 412). FIG. 5 further illustrates the information management server 502 communicatively connected with a user device 516 displaying a GUI 518 to a user 520. The user 520 may be, for example, a provider, a service provider, an engineer, a technician, an employee, etc.). The user 520 may utilize the GUI 518 to produce a work order for a technician to perform an event (e.g., plug a cable into an open port, un-plug a cable to an open port). The information management server 502 may be for managing circuits in the central data communication location 506 at varying levels of granularity. For example, the information management server 502 may manage open circuits and/or closed circuits in the central data communication location 506 at a frame (e.g., frame 104 or 202) level, at a panel (e.g., panel 204) level, a tray (e.g., tray 304 or 402) level, etc. The information management server 502 may also be configured to add in data from a DCIMS.

For example, the information management server 502 may store in its memory 510 individual circuits, equipment, architecture, and customers tracked by the DCIMS. The information management server 502 may store in its memory 510 data representing association information indicating identifiers (e.g., identifiers 108) associated with frames (e.g., frames 104), identifiers (e.g., identifiers 206) associated with panels (e.g., panels 204), identifiers (e.g., identifiers 312) associated with trays (e.g., patch trays 304), and identifiers (e.g., identifiers 416) associated with ports (e.g., ports 404). The identifiers associated with the frames, panels, trays, and ports, etc. may be stored as a data communication equipment list in the memory 510 of the information management server 502.

The data communication equipment list may be associated with the central data communication location 506. The data communication equipment list may allow a selection of a piece of data communication equipment to be located in the central data communication location 506. The data communication equipment list may provide for the information management server 502 to send data, to the AI algorithm, representing association information indicating an identifier is associated with a piece of data communication equipment. The data communication equipment list may also allow a selection of a piece of data communication equipment to be audited for open ports and/or closed ports.

The memory 510 may store instructions executable on the processor(s) 508 to receive data representing location information of open ports and/or closed ports. The central server 502 may store the data representing the location information of the open ports and/or closed ports in the memory 510. The memory 510 may store instructions executable on the processor(s) 508 to associate the location information of the open ports and/or the closed ports with representative locations in a digital representation of a piece of data communication equipment, to create a map of a digital representation of open ports and/or closed ports located in the piece of data communication equipment.

For example, the memory 510 may store instructions executable on the processor(s) 508 to associate the location information of the open ports and/or the closed ports with representative locations in trays, panels, chassis, or frames arranged in the central data communication location 506 to create a map of digital representations of open ports and/or closed ports arranged in the trays, the panels, the chassis, or the frames arranged in the central data communication location 506. The memory 510 may store instructions executable on the processor(s) 508 to associate the location information of the open ports and/or the closed ports with representative locations in the digital representation of the piece of data communication equipment within an amount of certainty. For example, the information management server 502 may compare the location information of the open ports and/or the closed ports with data representing location information tracked by the DCIMS to determine the location information of the open ports and/or the closed ports within an amount of certainty (e.g., 90% certainty). In another example, the information management server 502 may compare the location information of the open ports and/or closed ports with the data representing location information tracked by the DCIMS to validate an event (e.g., a cable was plugged into an open port, a cable was un-plugged from a closed port) within an amount of certainty (e.g., 90% certainty).

The GUI may be configured to allow a user to audit the data representing location information of open ports and/or closed ports. The GUI may be configured to allow a user to audit the map of the digital representation of the open ports and/or the closed ports arranged in the piece of data communication equipment.

The memory 510 may store instructions executable on the processor(s) 508 to receive data representing a plurality of reported events, each reported event being identified with a respective piece of data communication equipment. For example, the memory 510 may store instructions executable on the processor(s) 508 to receive data representing a plurality of reported events, each reported event being identified with the trays, the panels, the chassis, or the frames arranged in the central data communication location 506. The plurality of events may be, for example, accessing a frame, accessing a chassis, accessing a panel, accessing a tray, accessing an adapter, accessing a pop-up adapter, plugging in a cable, un-plugging a cable, patching a cable, splicing a cable, etc. The GUI may be configured to allow a user to audit data associated with the events of each a respective piece of data communication equipment.

The memory 510 may store instructions executable on the processor(s) 508 to validate the events identified with the respective piece of data communication equipment. For example, the memory 510 may store instructions executable on the processor(s) 508 to validate a cable was plugged into an identified open port. For example, to validate a cable was correctly plugged into an identified open port, the memory 510 may store instructions executable on the processor(s) 508 to compare an identified open port (e.g., open port 408) void of a cable plugged thereto, to an identified closed port having a cable plugged thereto that is in the same location as the identified open port before the cable was plugged thereto.

In another example, an engineer associated with the DCIM may specify a cable is to be plugged into an identified open port (e.g., open port 408) void of a cable plugged thereto. Data representing a work order may be sent to the central data communication location 506 where the work order may be received by a technician. The work order may be printed. Tag data may be sent to the central data communication location 506 where a tag (e.g., a label) may be printed. A technician, may utilize the work order and/or the tag to plug the cable into the identified open port. The technician may tag the cable. The tag may be applied to the cable before the cable is plugged into the open port or the tag may be applied to the cable after the cable is plugged into the open port. To validate the cable is plugged into the identified open port as specified by the engineer, the image capturing device 110 may capture an image of the tag attached to the cable and the cable plugged into the once open port. The memory 510 may store instructions executable on the processor(s) 508 to compare the image captured of the tag attached to the cable plugged into the port to an identified closed port having the location as the identified open port specified by the engineer. The memory 510 may further store instructions executable on the processor(s) 508 to compare location information printed on the tag to an identified location of the identified closed port having the location as the identified open port specified by the engineer. The memory 510 may store instructions executable on the processor(s) 508 to store the validation information of the cable being plugged into the identified open port as specified by the engineer.

In another example, to validate a cable was correctly un-plugged from an identified closed port, the memory 510 may store instructions executable on the processor(s) 508 to compare an identified closed port (e.g., closed port 412) having a cable plugged thereto, to an identified open port void of a cable plugged thereto that is in the same location as the identified closed port before the cable was un-plugged therefrom. Because the events are validated (e.g., a cable was plugged into the correct port and/or a cable was un-plugged from the correct port), a provider may be able to ensure full utilization of the data communication equipment arranged in the central data communication location 506.

In another example, an engineer associated with the DCIM may specify a cable is to be un-plugged from an identified closed port (e.g., closed port 412) having the cable plugged thereto. A work order may be sent to the central data communication location 506 where the work order may be received by a technician. The work order may be printed. Tag data may be sent to the central data communication location 506 where a tag (e.g., a label) may be printed. A technician, may utilize the work order and/or the tag to un-plug the cable from the identified closed port. The technician may tag the cable and/or the port. The tag may be applied to the cable and/or the port before the cable is un-plugged from the closed port or the tag may be applied to the cable and/or the port after the cable is un-plugged from the closed port. To validate the cable is un-plugged from the identified closed port as specified by the engineer, the image capturing device 110 may capture an image of now open port and/or the tag attached to the now open port. The memory 510 may store instructions executable on the processor(s) 508 to compare the image captured of the now open port and/or the tag attached to the now open port to an identified open port having the location as the identified closed port specified by the engineer. The memory 510 may further store instructions executable on the processor(s) 508 to compare location information printed on the tag attached to the now open port to an identified location of the identified open port having the location as the identified closed port specified by the engineer. The memory 510 may store instructions executable on the processor(s) 508 to store the validation information of the cable being un-plugged from the identified closed port as specified by the engineer.

### Illustrative Methods for Managing Circuits

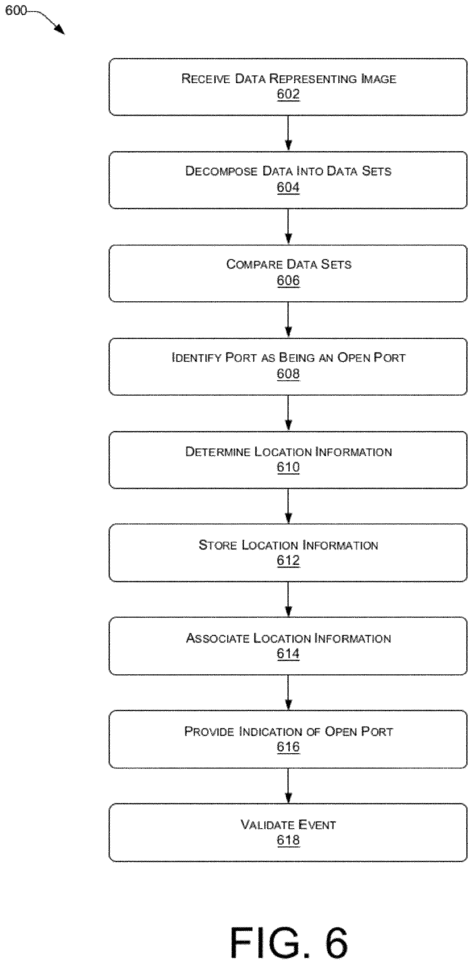

FIG. 6 illustrates an example method 600 for managing circuits. For instance, this process may be performed to manage open ports and closed ports of thousands of circuits to fully utilize floor space of central data communication locations and meet the high density needs of the central data communication locations. Further, this process (as well as each process described herein) may be performed to avoid using costly tracking systems having identifiers (e.g., a radio-frequency identifier (RFID), a printed circuit board (PCB), etc.) arranged in a connector of each patch cord that cooperate with sensor panels (e.g., RFID sensor panels, PCB sensor panels, etc.). Rather, a service provider may elect to perform this process with existing data communication equipment already installed in central data communication locations. While FIG. 6 illustrates a method of managing circuits in central data communication locations, this method (as well as each method described herein) may apply to managing circuits used in other fields such as in a power environment to manage open power ports and closed power ports, in an industrial environment to manage open power ports and closed power ports, in an electric utility environment to manage open power ports and closed power ports, a radio environment to manage open ports and closed ports, in a television environment to manage open ports and closed ports, etc. Further, while FIG. 6 illustrates a method of managing open ports and closed ports that are patch ports, this method (as well as each method described herein) may apply to managing open switches and closed switches.

The method 600 (as well as each method described herein) is illustrated as a logical flow graph, each operation of which represents a sequence of operations that can be implemented in hardware, software, or a combination thereof. In the context of software, the operations represent computer-executable instructions stored on one or more non-transitory computer-readable storage media that, when executed by one or more processors, perform the recited operations. Generally, computer-executable instructions include routines, programs, objects, components, data structures, and the like that perform particular functions or implement particular abstract data types. The order in which the operations are described is not intended to be construed as a limitation, and any number of the described operations can be combined in any order and/or in parallel to implement the process.

Method 600 may include operation 602, which represents receiving data representing an image (e.g., image 112, 208, 314, or 406), captured via an image capturing device (e.g., image capturing device 110), of a piece of data communication equipment (e.g., frames 104, panels 204, or trays 304) having ports (e.g., ports 306 or 404). For example, an artificial intelligence (AI) algorithm (Microsoft Computer Vision API, Amazon Rekognition, a Google Cloud Vision API, OpenCV, SimpleCV, etc.) may receive the data representing the image, captured via the image capturing device, of the piece of data communication equipment having ports.

Operation 602 may be followed by operation 604, which represents decomposing the data into data sets representing images of the ports. For example, the AI algorithm may decompose the data into data sets representing images of the ports.

Method 600 may continue with operation 606, which represents comparing the data sets representing the images of the ports to a trained data set of known images of open ports, the images of the open ports void of a cable plugged thereto. For example, the AI algorithm may compare the data sets representing the images of the ports to a trained data set of known images of open ports void of a cable plugged thereto.

Method 600 may include operation 608, which represents identifying, based at least in part on the comparing, a port of the images of the ports as being an open port (e.g., open port 408). For example, the AI algorithm may identify, based at least in part on the comparing, a port of the images of the ports as being an open port.

Method 600 may include operation 610, which represents determining location information, of the open port, relative to the piece of data communication equipment. For example, the AI algorithm may determine location information, of the open port, relative to a patch tray (e.g., patch tray 402) in an open position (e.g., open position 308).

In one example, determining location information, of the open port, relative to the patch tray in the open position includes the AI algorithm associating the open port with the patch tray in the open position having been previously associated with an identifier (e.g., identifier 312). For example, the AI algorithm may associate the open port with the patch tray in the open position if the open port is within a threshold distance of the identifier having been previously associated with the patch tray in the open position.

In another example, determining location information, of the open port, relative to the patch tray in the open position includes the AI algorithm determining location information, of the open port, relative to the patch in the open position by decomposing the data representing the image (e.g., image 406) into data sets representing images of identifiers (e.g., identifiers 416) associated with the ports (e.g., ports 404). The AI algorithm may compare the data sets representing the images of the identifiers to a trained data set of known images of identifiers. The AI algorithm may identify, based at least in part on the comparing, at least one image of an identifier as being the identifier. The AI algorithm may associate the at least one image of the identifier with the open port. For example, the AI algorithm may determine the at least one image of the identifier is within a threshold distance of the open port and associate the at least one image of the identifier with the open port. In another example, the AI algorithm may receive data representing association information indicating the at least one image of the identifier is associated with the open port.

Method 600 may include operation 612, which represents storing, via memory of a central server (e.g., information management server 502), the location information of the open port.

Method 600 may include operation 614, which represents the central server associating the location information, of the open port, with a representative location in a digital representation of the piece of data communication equipment, to create a map of a digital representation of open ports arranged in the piece of data communication equipment.

Method 600 may include operation 616, which represents providing an indication (e.g., indication 410) of the open ports. For example, the AI algorithm may provide an icon indicating, outlining, demarcating, signaling, etc., the open port in the image of the ports.

Method 600 may be complete at operation 618, which represents validating an event. For example, the central server may validate a cable was plugged into the identified open port. Operation 618 may include providing a token to represent the validation of the event. For example, the central server may provide a tag (e.g., a label) to be applied to a port or a cable associated with the open port or the cable plugged thereto. The tag may include identification information. For example, the tag may include "To" and/or "From" location information. For example, the "To" location information may be an address (e.g., rack number, panel number, port number) of the other end of the cable. Similarly, the "From" location information may be an address (e.g., rack number, panel number, port number) of the end of the cable being tagged. The central server may store the validation information in memory (e.g., memory 510). The tag may be printed, via a portable printer, located at the central data communication location 506. For example, the DCIMS may send, via Wi-Fi, instructions to a portable printer located at the central data communication location 506 to print a tag to be applied to the cable to validate the event.

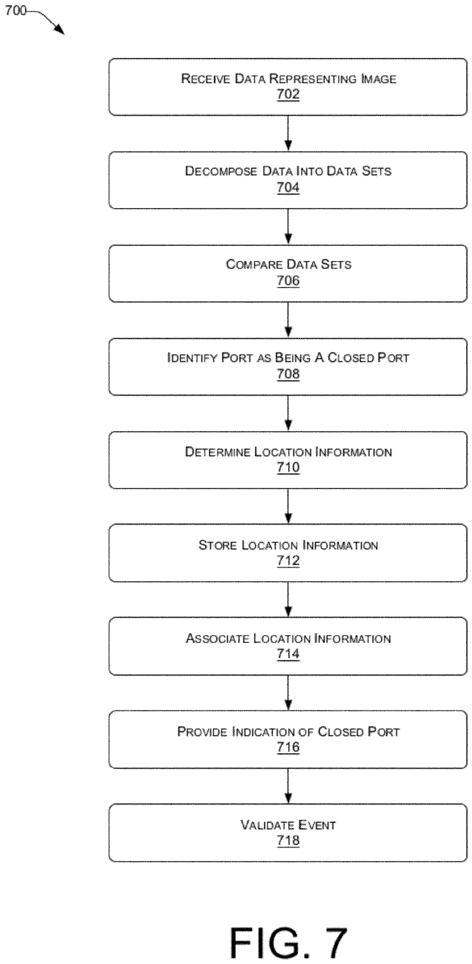

FIG. 7 illustrates an example method 700 for managing circuits. For instance, this process may be performed to manage open ports and closed ports of thousands of circuits to fully utilize floor space of central data communication locations and meet the high density needs of the central data communication locations.

Method 700 may include operation 702, which represents receiving data representing an image (e.g., image 112, 208, 314, or 406), captured via an image capturing device (e.g., image capturing device 110), of a piece of data communication equipment (e.g., frames 104, panels 204, or trays 304) having ports (e.g., ports 306 or 404). For example, an artificial intelligence (AI) algorithm (Microsoft Computer Vision API, Amazon Rekognition, a Google Cloud Vision API, OpenCV, SimpleCV, etc.) may receive the data representing the image, captured via the image capturing device, of the piece of data communication equipment having ports.

Operation 702 may be followed by operation 704, which represents decomposing the data into data sets representing images of the ports. For example, the AI algorithm may decompose the data into data sets representing images of the ports.

Method 700 may continue with operation 706, which represents comparing the data sets representing the images of the ports to a trained data set of known images of closed ports, the images of the closed ports void of a cable plugged thereto. For example, the AI algorithm may compare the data sets representing the images of the ports to a trained data set of known images of closed ports having a cable plugged thereto.

Method 700 may include operation 708, which represents identifying, based at least in part on the comparing, a port of the images of the ports as being a closed port (e.g., closed port 412). For example, the AI algorithm may identify, based at least in part on the comparing, a port of the images of the ports as being a closed port.

Method 700 may include operation 710, which represents determining location information, of the closed port, relative to the piece of data communication equipment. For example, the AI algorithm may determine location information, of the closed port, relative to a patch tray (e.g., patch tray 402) in an open position (e.g., open position 308).

In one example, determining location information, of the closed port, relative to the patch tray in the open position includes the AI algorithm associating the closed port with the patch tray in the open position having been previously associated with an identifier (e.g., identifier 312). For example, the AI algorithm may associate the closed port with the patch tray in the open position if the closed port is within a threshold distance of the identifier having been previously associated with the patch tray in the open position.

In another example, determining location information, of the closed port, relative to the patch tray in the open position includes the AI algorithm determining location information, of the closed port, relative to the patch in the open position by decomposing the data representing the image (e.g., image 406) into data sets representing images of identifiers (e.g., identifiers 416) associated with the ports (e.g., ports 404). The AI algorithm may compare the data sets representing the images of the identifiers to a trained data set of known images of identifiers. The AI algorithm may identify, based at least in part on the comparing, at least one image of an identifier as being the identifier. The AI algorithm may associate the at least one image of the identifier with the closed port. For example, the AI algorithm may determine the at least one image of the identifier is within a threshold distance of the closed port and associate the at least one image of the identifier with the closed port. In another example, the AI algorithm may receive data representing association information indicating the at least one image of the identifier is associated with the closed port.

Method 700 may include operation 712, which represents storing, via memory of a central server (e.g., information management server 502), the location information of the closed port.

Method 700 may include operation 714, which represents the central server associating the location information, of the closed port, with a representative location in a digital representation of the piece of data communication equipment, to create a map of a digital representation of closed ports arranged in the piece of data communication equipment.

Method 700 may include operation 716, which represents providing an indication (e.g., indication 414) of the closed ports. For example, the AI algorithm may provide an icon indicating, outlining, demarcating, signaling, etc., the closed port in the image of the ports.

Method 700 may be complete at operation 718, which represents validating an event. For example, the central server may validate a cable was un-plugged from the identified closed port. Operation 718 may include providing a token to represent the validation of the event. For example, the central server may provide a tag to be applied to a port or a cable associated with the closed port or the un-plugged cable. The tag may include identification information. For example, the tag may include "To" and/or "From" location information. For example, the "To" location information may be an address (e.g., rack number, panel number, port number) of the other end of the cable. Similarly, the "From" location information may be an address (e.g., rack number, panel number, port number) of the end of the cable being tagged. The central server may store the validation information in memory (e.g., memory 510).

### Clauses

A. A method of managing circuits, the method comprising: receiving data representing an image, captured via an image capturing device, of a piece of data communication equipment having ports; decomposing the data into data sets representing images of the ports; comparing the data sets representing the images of the ports to a trained data set of known images of open ports, the images of the open ports void of a cable plugged thereto; and identifying, based at least in part on the comparing, a port of the images of the ports as being an open port.
B. A method as paragraph A recites, wherein the ports include fiber optic ports, the images of the open ports are images of open fiber optic ports, and the port is an open fiber optic port that is void of a fiber optic cable plugged thereto.
C. A method as paragraph A or B recites, further comprising determining location information, of the open port, relative to the piece of data communication equipment.
D. A method as any one of paragraphs A through C recites, further comprising storing, via memory of a central server, the location information of the open port.
E. A method as any one of paragraphs A through D recites, wherein the central server associates the location information, of the open port, with a representative location in a digital representation of the piece of data communication equipment, to create a map of a digital representation of open ports arranged in the piece of data communication equipment.
F. A method as any one of paragraphs A through E recites, wherein the determining of the location information includes: decomposing the data into data sets representing images of identifiers associated with the piece of data communication equipment; comparing the data sets representing the images of the identifiers to a trained data set of known images of identifiers; identifying, based at least in part on the comparing, at least one image of an identifier of the images of the identifiers as being an identifier; and associating the at least one image of the identifier with the open port.
G. A method as any one of paragraphs A through F recites, wherein the at least one image of the identifier associated with the open port includes an image of a machine-readable code, an image of one or more alphabetical characters, or an image of one or more numerical characters.
H. A method as any one of paragraphs A through G recites, further comprising: receiving data representing a work order, the work order specifying the cable is to be plugged into the open port; and validating the cable is plugged into the open port.
I. A method of managing circuits, the method comprising: receiving data representing an image, captured via an image capturing device, of a piece of data communication equipment having ports; decomposing the data into data sets representing images of the ports; comparing the data sets representing the images of the ports to a trained data set of known images of closed ports, the images of the closed ports having a cable plugged thereto; and identifying, based at least in part on the comparing, a port of the images of the ports as being a closed port.
J. A method as paragraph I recites, wherein the ports include fiber optic ports, the images of the closed ports are images of closed fiber optic ports, and the port is a fiber optic port having a fiber optic cable plugged thereto.
K. A method as paragraph I or J recites, further comprising determining location information, of the closed port, relative to the piece of data communication equipment.
L. A method as any one of paragraphs I through K recites, further comprising storing, via memory of a central server, the location information of the closed port.
M. A method as any one of paragraphs I through L recites, wherein the central server associates the location information, of the closed port, with a representative location in a digital representation of the piece of data communication equipment, to create a map of a digital representation of closed ports arranged in the piece of data communication equipment.
N. A method as any one of paragraphs I through M recites, wherein the determining of the location information includes: decomposing the data into data sets representing images of identifiers associated with the piece of data communication equipment; comparing the data sets representing the images of the identifiers to a trained data set of known images of identifiers; identifying, based at least in part on the comparing, at least one image of an identifier of the images of the identifiers as being an identifier; and associating the at least one image of the identifier with the closed port.
O. A method as any one of paragraphs I through N recites, wherein the at least one image of the identifier associated with the closed port includes an image of a machine-readable code, an image of one or more alphabetical characters, or an image of one or more numerical characters.
P. A method as any one of paragraphs I through O recites, further comprising: receiving data representing a work order, the work order specifying the cable is to be un-plugged from the closed port; and validating the cable is un-plugged from the closed port.
Q. A method of managing circuits, the method comprising: capturing, via an image capturing device, an image of a piece of data communication equipment having ports; decomposing the image into images of open ports of the piece of data communication equipment, the images of the open ports void of a cable plugged thereto; identifying the open ports as being open; and providing an indication of the open ports.
R. A method as paragraph Q recites, wherein the ports include fiber optic ports, the images of the open ports include images of open fiber optic ports, and the images of the open fiber optic ports are void of a fiber optic cable plugged thereto.
S. A method as paragraph Q or R recites, further comprising determining location information, of the open ports, relative to the piece of data communication equipment, wherein the determining of the location information includes: decomposing the image into images of identifiers associated with the piece of data communication equipment; identifying the identifiers; and associating the identifiers with the open ports.
T. A method as any one of paragraphs Q through S recites, wherein the identifiers include a machine-readable code, one or more alphabetical characters, or one or more numerical characters.

### Conclusion

Although the invention has been described in language specific to structural features and/or methodological acts, it is to be understood that the invention is not necessarily limited to the specific features or acts described. Rather, the specific features and acts are disclosed as illustrative forms of implementing the invention. For example, while embodiments are described having certain shapes, sizes, and configurations, these shapes, sizes, and configurations are merely illustrative.

## Claims

1. A method of managing circuits, the method comprising:
receiving data representing an image, captured via an image capturing device, of a piece of data communication equipment having ports;
decomposing the data into data sets representing images of the ports;
comparing the data sets representing the images of the ports to a trained data set of known images of open ports, the images of the open ports void of a cable plugged thereto; and
identifying, based at least in part on the comparing, a port of the images of the ports as being an open port.

2. The method of claim 1, wherein the ports include fiber optic ports, the images of the open ports are images of open fiber optic ports, and the port is an open fiber optic port that is void of a fiber optic cable plugged thereto.

3. The method of claim 1, further comprising determining location information, of the open port, relative to the piece of data communication equipment.

4. The method of claim 3, further comprising storing, via memory of a central server, the location information of the open port.

5. The method of claim 4, wherein the central server associates the location information, of the open port, with a representative location in a digital representation of the piece of data communication equipment, to create a map of a digital representation of open ports arranged in the piece of data communication equipment.

6. The method of claim 3, wherein the determining of the location information includes:
decomposing the data into data sets representing images of identifiers associated with the piece of data communication equipment;
comparing the data sets representing the images of the identifiers to a trained data set of known images of identifiers;
identifying, based at least in part on the comparing, at least one image of an identifier of the images of the identifiers as being an identifier; and
associating the at least one image of the identifier with the open port.

7. The method of claim 1, further comprising:
receiving data representing a work order, the work order specifying the cable is to be plugged into the open port; and
validating the cable is plugged into the open port.

8. A method of managing circuits, the method comprising:
receiving data representing an image, captured via an image capturing device, of a piece of data communication equipment having ports;
decomposing the data into data sets representing images of the ports;
comparing the data sets representing the images of the ports to a trained data set of known images of closed ports, the images of the closed ports having a cable plugged thereto; and
identifying, based at least in part on the comparing, a port of the images of the ports as being a closed port.

9. The method of claim 8, wherein the ports include fiber optic ports, the images of the closed ports are images of closed fiber optic ports, and the port is a fiber optic port having a fiber optic cable plugged thereto.

10. The method of claim 8, further comprising determining location information, of the closed port, relative to the piece of data communication equipment.

11. The method of claim 10, further comprising storing, via memory of a central server, the location information of the closed port.

12. The method of claim 11, wherein the central server associates the location information, of the closed port, with a representative location in a digital representation of the piece of data communication equipment, to create a map of a digital representation of closed ports arranged in the piece of data communication equipment.

13. The method of claim 11, wherein the determining of the location information includes:
decomposing the data into data sets representing images of identifiers associated with the piece of data communication equipment;
comparing the data sets representing the images of the identifiers to a trained data set of known images of identifiers;
identifying, based at least in part on the comparing, at least one image of an identifier of the images of the identifiers as being an identifier; and
associating the at least one image of the identifier with the closed port.

14. The method of claim 6 or claim 13, wherein the at least one image of the identifier associated with the identified open or closed port includes an image of a machine-readable code, an image of one or more alphabetical characters, or an image of one or more numerical characters.

15. The method of claim 8, further comprising:
receiving data representing a work order, the work order specifying the cable is to be un-plugged from the closed port; and
validating the cable is un-plugged from the closed port.
